Europäisches Patentamt

(19) European Patent Office (11) Publication number: **0 222 960**

Office européen des brevets **B1**

(12) **EUROPEAN PATENT SPECIFICATION**

(45) Date of publication of the patent specification: (51) Int. Cl.⁴: **C03C 25/02, C23C 16/34**
08.03.89

(21) Application number: **85810546.3**

(22) Date of filing: **18.11.85**

(54) **Method and apparatus for the on-line coating of silica based fibers with boron-nitride.**

(43) Date of publication of application:
**27.05.87 Bulletin 87/22**

(45) Publication of the grant of the patent:
**08.03.89 Bulletin 89/10**

(84) Designated Contracting States:
**CH DE FR GB IT LI SE**

(56) References cited:
**EP-A- 0 095 729**
**FR-A- 1 358 140**

**"VAPOR DEPOSITION", 1966, pages 378-385,416-419, edited by C.F. Powell et al., published by John Wiley & Sons, Inc., New York, US.**
**CHEMICAL ABSTRACTS, vol. 103, no. 2, 15th July 1985, page 627, abstract no. 15588s, Columbus, Ohio, US; & JP - A - 60 15 933 (NEC CORP.) 26-01-1985**

(73) Proprietor: **BATTELLE MEMORIAL INSTITUTE, 7 route de Drize, CH-1227 Carouge/Genève(CH)**

(72) Inventor: **Schachner, Herbert, 103, Av. du Bois de la Chapelle, CH-1213 Onex(CH)**
Inventor: **Tippmann, Heinz, 2, chemin des Platières, CH-1219 Geneva(CH)**
Inventor: **Oberson, Bernard, 6, Rue de l'Est, CH-1207 Geneva(CH)**

(74) Representative: **Dousse, Blasco et al, 7, route de Drize, CH-1227 Carouge/Genève(CH)**

ACTORUM AG

## Description

### Field of the invention

The present invention relates to the coating of silica optical fibers with protective minerals to improve their physical properties, more especially their resistance to corrosion and fatigue with time under use stress at elevated temperature.

### The prior art

It has been known for long that glass and silica fibers (called "glass fibers" hereafter for short) need resistance to strong mechanical stress under practical uses, i.e. when manipulated for making fabrics or optical communication lines. Furthermore, the initial properties of the fibers are often detrimentally affected by external agents such as polluted air, humidity and corrosive atmospheres. These drawbacks mainly result from tiny cracks and crazes in the fiber surface due to mechanical handling during drawing or further manipulations; in the long run, these surface defects amplify and initiate fissure formation and ultimate rupture or other kind of failure.

It has therefore been long sought to remedy the situation by coating the fibers with a protective mineral coating impervious to external agents and providing mechanical reinforcement to the fiber and protection against high temperatures. Many coatings have been tried including silicon oxynitride, silicon nitride, carbon, metals such as Ni and Al, titania and various other metal oxides such as $Al_2O_3$, $ZrO_2$, $SnO_2$, etc., see for instance "Third International Conference on Integrated Optics and optical Fiber Communication (1981) San-Francisco, Cal.": C.R. KURJIAN, Recent Progress in the strength of Fibers, p. 22; S.M. OH et al, Increased Durability of Optical Fibers through the Use of Compressed Cladding, p. 24; E.G. HANSON et al, Reduction of Static Fatigue in Optical Fibers by Use of a Silicon Oxynitride Coating, p. 24. Other references are: P. EHRBURGER et al, Ceramic Bulletin 59, (1980), 844–847; FR-A 2 320 915 (QUARTZ & SILICE).

Recently, the use of BN as a protective cladding on fibers has been proposed in US-A 4 118 211.

Several methods for coating boron nitride on glass fibers have been proposed, some of which are listed below:

FEURER et al in "Coatings of boron nitride on silica by thermal decomposition of hexachloroborazine" in Proc. Eur. Conf. Chem. Vap. Deposition, 3d 1980, 49–55 (C.A. 95, 174092) disclose that hexagonal BN was deposited by VPC at 900°C from $B_3N_3Cl_6$ to provide 0.5–1 µm films with good adhesion to $SiO_2$.

SANO et al: "Chemical vapor deposition of thin films of boron nitride onto fused silica and sapphire" in Thin Solid Films 1981, 83(2), 247–51 (C.A. 95: 213137) disclose that BN films were grown on silica at a rate of about 0.5 µm/h using the reaction $BCl_3 + NH_3$ at 600–1100°C. Such rate would be insufficient to provide a protective coating on optical fibers by an on-line deposition method.

SAVELEV et al: "Properties of boron nitride films produced by decomposition of borazine in a high-frequency plasma" in Fiz. Khim. Obrab. Mater 1891, (2), 85–8, report the conversion of borazine to BN in a high-frequency electric discharge with a deposition rate of 3–4 µm/hr.

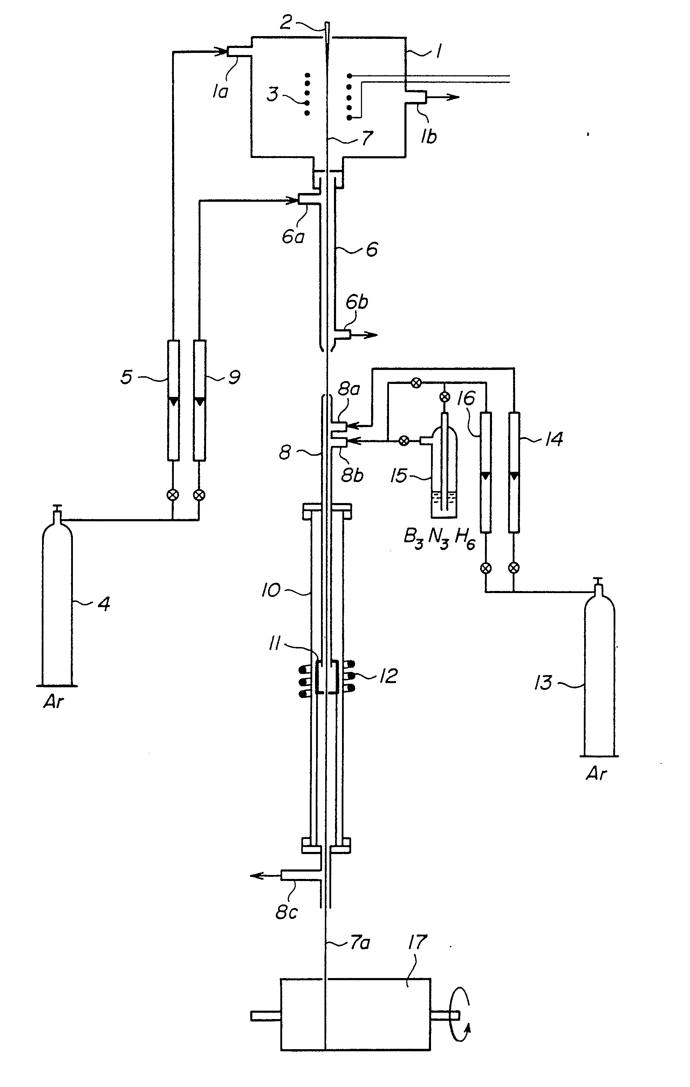

Obviously the techniques disclosed in the prior art are much too slow for the on-line cladding of silica fibers in the drawing of preforms which can easily reach velocities in the range of 10 m/min or more. Indeed, if it is assumed that an on-line BN coating reactor can have approximately 0.1–0.3 m in length, the holding time at 10 m/min will be about 0.1 to 2 sec. If it is assumed that the thickness of the BN coating to be efficiently protective should be at least 0.01 µm, the deposition rate will have to be in the range of 0.2–0.6 µm/min.

### Description of the invention

The method of the invention enables to achieve such performances.

The method for the on-line coating of silica fibers with a protective shielding film of boron nitride according to the invention is characterized by the following steps:

(i) drawing a fiber from a silica preform at a temperature of 1900 to 2000°C under a blanket sheath of an inert gas;

(ii) on-line passing said hot drawn fiber into a vertically oriented quartz tube provided with means for heating the moving fiber to a temperature of 900–1150°C;

(iii) circulating into said quartz tube a gaseous mixture of borazine and an inert gas at a concentration and a rate sufficient to provide by CVD on the moving fiber a boron nitride coating resulting from the pyrolysis of said borazine, said coating being at least 0.01 µm thick;

(iv) on-line withdrawing the coated fiber from said quartz tube and allowing it to cool for winding on a spool.

This method can be implemented practically by means of an apparatus comprising:

a) means for heating a glass preform to the melt drawing temperature under a blanket of inert gas,

b) means for drawing a fiber from said heated preform and spooling it on rotating cylinder,

c) coating means interposed between the drawing and the spooling means for coating the fiber with a protective film of boron nitride, said coating means consisting of a vertical quartz tube axially passed through by said fiber and containing a HF heated graphite susceptor flushed by a gaseous flow of borazine diluted in an inert gas.

## Description of the preferred embodiments

The inert gas used as a blanket for drawing the fiber preform and as a diluent to the borazine can be a noble gas such as helium, neon, krypton or xenon; argon is preferred for reasons of easy availability.

The temperature at which the preform is heated to effect drawing is not critical provided it is sufficient to enable the drawing of about 50 to 200 µm thick fibers at a rate of about 2–20 m/min. The drawing temperatures are in the range of 1900 to 2200°C.

The proportion of borazine in the gas mixture that circulates in the quartz coating tube and the flowing rate of said mixture is dependent on the desired coating performances. In other words, the higher the depositing rate sought after, the higher the borazine concentration in the gas or the faster the circulation of the gas mixture. However, care must be taken to match the rate of arrival of the borazine reagent with the rate of thermal decomposition of said reagent in contact with the moving fiber in the coating enclosure. Appropriate operative parameters are in the case of fiber drawing speeds of 2–20 m/min: CVD temperature, 900–1150°C; total gas mixture flow, 0.5–5 l/min; borazine concentration in the argon carrier, 0.1–1.5% v/v; optimal borazine concentrations are in the 0.2–0.6% range. In this cases the coating thickness may range from a few nm to a few hundreds nm.

## Brief description of the drawing

The annexed drawing schematically illustrates an installation for coating optical fibers with a boron nitride protective layer.

## The apparatus

The illustrated apparatus comprises a furnace enclosure 1 for the melting and drawing of an optical silica preform 2 under the heating of a heating element 3 connected to an energy source not represented. The furnace 1 is connected by an inlet 1a to an argon supply 4 via a flow-meter 5. An outlet 1b of the furnace 1 relieves a possible over-pressure due to an excess of blanketing argon.

The enclosure 1 is provided at the bottom thereof with a leader tube 6, made of quartz, which enables to direct a fiber 7 drawn from preform 2 to penetrate into another tube 8 coaxial with tube 6. Tube 6 is also provided with gas inlet and outlet openings, respectively 6a and 6b, for connecting to the argon source 4 via a flowmeter 9.

The tube 8 is wrapped in a mantle 10 and opens up into a graphite susceptor 11 surrounded by a HF heating coil 12. The spacing between the tube 8 and the mantle 10 is preferably flushed with argon (through openings therein not represented) to prevent contamination by air. Situated substantially upstream of said susceptor, the tube 8 is provided with input openings 8a and 8b and downstream thereof with an outlet 8c. Input 8a is supplied with pure argon from a source 13, via a flowmeter 14 whereas input 8b is supplied with a borazine vapor/Ar mixture generated in a bubbling bottle 15 held at a constant controlled temperature under the effect of an argon stream circulating via a flowmeter 16. The borazine/argon mixture penetrates into tube 8 well ahead of the position of susceptor 11 relative to the fiber 7 displacement. Therefore the gas mixture is given ample time to homogeneize around said fiber and a homogeneous BN coating will result all around the fiber surface. The decomposition of the $B_3N_3H_6$ occurs in the graphite susceptor under the heat provided by induction from the HF coil 12. The exhausted gases then leave the tube 8 by the output 8c thereof.

In a modification of the above-mentioned equipment, a mixing bottle can be inserted in the path of the borazine/Ar mixture before penetrating into inlet 8b to further improve the mixing of the gases.

After exiting from tube 8 by its lower end, the coated fiber 7a is wound on a take-up rotating cylinder 17.

The operation of the present installation is self-understandable from the aforementioned description and needs only briefly reviewed.

After heating in the oven 1, the glass preform 2 is drawn into a fiber 7 which, after leaving tube 6, enters tube 8 and passes through susceptor 11 heated to the right temperature to effect the pyrolysis of the borazine component of the gas mixture supplied by the bottle 15. Thus, the fiber 7 gets coated with a film of boron nitride and is converted into coated fiber 7a which, after cooling, is finally collected on spool 17.

Reduction to practice

The following examples illustrate the invention

Examples 1 to 12

An apparatus such as that disclosed with reference to the annexed drawing was used. A series of experiments were carried out using silica based optical preforms of diameter 6–10 mm, length about 500 mm and an OH content less than 100 ppb. After drawing, the resulting fibers had a diameter of about 120–170 μm.

The operating parameters for examples 1 to 12 are listed in Table I below.

Table I

| Example No. | Fiber speed (m/min) | Suspector temperature (°C) | Heater length (cm) | Gas (Ar + $B_3N_3H_6$) | |
| | | | | composition (% $B_3N_3H_6$) | feed rate ($cm^3$/min) |
|---|---|---|---|---|---|
| 1 | 4 | 1100 | 6 | 0.4 | 2000 |
| 2 | 10 | 1100 | 15 | 0.4 | 2000 |
| 3 | 10 | 920 | 15 | 0.4 | 2000 |
| 4 | 2.5 | 1020 | 30 | 0.3 | 3000 |
| 5 | 12.5 | 1020 | 30 | 0.3 | 3000 |
| 6 | 4 | 1000 | 30 | 0.1 | 3000 |
| 7 | 4 | 1000 | 30 | 0.2 | 3000 |
| 8 | 4 | 1000 | 30 | 0.4 | 3000 |
| 9 | 4 | 1000 | 30 | 0.6 | 3000 |
| 10 | 4 | 1000 | 30 | 0.8 | 3000 |
| 11 | 4 | 1000 | 30 | 1.0 | 3000 |
| 12 (Control) | 4 | 1000 | 30 | 0.0 | 3000 |

The effect of the coating thus achieved was tested in the case of Examples 6–12 in connection with the minimum rupture bending radius. Results are shown below:

| Example No. | Bending radius (mm) |
|---|---|
| 6 | 6 |
| 7 | 7 |
| 8 | 7 |
| 9 | 7 |
| 10 | 10 |
| 11 | 10 |
| 12 (Control) | 10 |

It appears from the above data that optimal results are obtained with 0.1–0.6% $B_3N_3H_6$.

**Claims**

1. A method for the on-line coating of silica fibers with a protective shielding film of boron nitride, characterized in the steps of:
(i) drawing a fiber from a silica preform at a temperature of 1900 to 2200°C under a blanket sheath of an inert gas;

(ii) on-line passing said hot drawn fiber into a vertically oriented quartz tube provided with means for heating the moving fiber to a temperature of 900–1150°C;

(iii) circulating into said quartz tube a gaseous mixture of borazine and an inert gas at a concentration and a rate sufficient to provide by CVD on the moving fiber a boron nitride coating resulting from the pyrolysis of said borazine, said coating being at least 0.01 μm thick;

(iv) on-line withdrawing the coated fiber from said quartz tube and allowing it to cool for winding on a spool.

2. An apparatus for carrying out the method of claim 1, this apparatus comprising:

a) means for heating a glass preform to the melt drawing temperature under a blanket of inert gas,

b) means for drawing a fiber from said heated preform and spooling it on rotating cylinder,

c) coating means interposed between the drawing and the spooling means for coating the fiber with a protective film of boron nitride, said coating means consisting of a vertical quartz tube axially passed through by said fiber and containing a HF heated graphite susceptor flushed by a gaseous flow of borazine diluted in an inert gas.

3. The method of claim 1, characterized in that the speed of drawing of the fiber is from 2 to 20 m/min and the thickness of the boron-nitride coating is from 10 nm to 1 μm.

4. The method of claim 1, characterized by the fact that it provides to the fibers a protection against loss of strength even after heating for more than 100 hours at 900°C.

## Patentansprüche

1. Verfahren zum ununterbrochenen Beschichten von Quarzfasern mit einem Schutzfilm aus Bornitrid, gekennzeichnet, durch die Stufen:

(i) Ziehen einer Faser aus einem Quarz-Vorformling bei einer Temperatur von 1900 bis 2200°C unter einer Inertgasschutzhülle;

(ii) ununterbrochenes Hindurchführen dieser heißgezogenen Faser durch ein mit Mitteln zum Erhitzen der sich bewegenden Faser auf eine Temperatur von 900 bis 1150°C versehenes senkrecht orientiertes Quarzrohr;

(iii) Umlaufenlassen eines gasförmigen Gemisches aus Borazin und einem Inertgas in diesem Quarzrohr bei einer Konzentration und einer Geschwindigkeit, die zum Schaffen einer aus der Pyrolyse des Borazins resultierenden Bornitridbeschichtung durch CVD auf der sich bewegenden Faser ausreichend sind, wobei die Beschichtung mindestens 0,01 μm dick ist;

(iv) ununterbrochenes Herausziehen der beschichteten Faser aus dem Quarzrohr und Abkühlenlassen zum Wickeln zu einer Spule.

2. Vorrichtung zur Durchführung des Verfahrens nach Anspruch 1, wobei diese Vorrichtung besteht aus:

a) Mitteln zum Erhitzen eines Glas-Vorformlings auf die Schmelzziehtemperatur unter einem inerten Schutzgas,

b) Mitteln zum Ziehen einer Faser aus dem erhitzten Vorformling und Aufspulen auf einen rotierenden Zylinder,

c) Beschichtungsmitteln, die zwischen den Zieh- und den Aufspulmitteln angeordnet sind, zum Beschichten der Faser mit einem Schutzfilm aus Bornitrid, wobei diese Beschichtungsmittel aus einem senkrechten Quarzrohr bestehen, das von der genannten Faser axial durchlaufen wird und das einen HF-erhitzten Graphitsuszeptor enthält, der durch einen gasförmigen Strom von mit Inertgas verdünntem Borazin gespült wird.

3. Verfahren nach Anspruch 1, dadurch gekennzeichnet, daß die Geschwindigkeit der gezogenen Faser 2 bis 20 m/min und die Dicke der Bornitridbeschichtung 10 nm bis 1 μm beträgt.

4. Verfahren nach Anspruch 1, gekennzeichnet durch die Tatsache, daß durch es die Fasern mit einem Schutz gegen Festigkeitsverlust sogar nach Erhitzen von mehr als 100 Stunden auf 900°C versehen werden.

## Revendications

1. Procédé pour revêtir directement lors de leur fabrication des fibres de silice par un film protecteur de nitrure de bore, caractérisé par les étapes suivantes:

(i) on étire sous forme de fibre une préforme de silice à une température de 1900 à 2200°C sous couverture protectrice de gaz inerte;

(ii) on fait directement passer cette fibre fraîchement étirée et chaude dans un tube de quartz vertical équipé de moyens pour chauffer la fibre en mouvement à une température de 900 à 1150°C;

(iii) on fait circuler dans ce tube de quartz un mélange gazeux de borazine et d'un gaz inerte dont la concentration et le débit sont suffisants pour engendrer la formation par CVD sur la fibre en mouvement un revêtement de nitrure de bore résultant de la pyrolyse de ladite borazine, l'épaisseur de ce revêtement étant d'au moins 0,01 μm.

(iv) on récolte la fibre revêtue directement à la sortie dudit tube de quartz et on la laisse refroidir pour l'enrouler en bobine.

2. Appareil pour mettre en œuvre le procédé de la revendication 1, qui comprend:

a) des moyens pour chauffer à fusion une préforme de verre sous couverture de gaz inerte;

b) des moyens pour étirer en fibre cette préforme chauffée et embobiner cette fibre sur un cylindre tournant;

c) des moyens de revêtement interposés entre l'étirage et l'embobinage pour revêtir la fibre d'un film protecteur de nitrure de bore, ces moyens de revêtement comprenant un tube de quartz vertical parcouru axialement par ladite fibre et contenant un suscepteur de graphite chauffé par haute fréquence et balayé par un flux gazeux de borazine diluée par un gaz inerte.

3. Le procédé de la revendication 1, caractérisé en ce que la vitesse d'étirage de la fibre est de 2 à 20 m/min et que l'épaisseur du manchon de nitrure de bore est de 10 nm à 1 μm.

4. Le procédé de la revendication 1, caractérisé en ce qu'il fournit à la fibre une protection contre les pertes de ténacité, même après plus de 100 h de chauffe à 900°C.

EP 0 222 960 B1